# EUROPÄISCHE PATENTSCHRIFT

(11) **EP 2 087 320 B1**
(45) Veröffentlichungstag und Bekanntmachung des Hinweises auf die Patenterteilung: **06.11.2019**
(21) Anmeldenummer: 07820678.6
(22) Anmeldetag: 28.09.2007
(51) Int. Cl.: G01D 5/20

(54) **VERFAHREN ZUR HERSTELLUNG EINES TRÄGERELEMENTS MIT EINEM WINKELSENSOR**
METHOD FOR MANUFACTURING A MOUNTING ELEMENT WITH AN ANGLE SENSOR
PROCÉDÉ POUR LA FABRICATION D'UN ÉLÉMENT PORTEUR AVEC UN DÉTECTEUR D'ANGLE

(30) Priorität: 04.10.2006 DE 102006046984
(43) Veröffentlichungstag der Anmeldung: 12.08.2009
(73) Patentinhaber: CPT Group GmbH, 30165 Hannover (DE)
(72) Erfinder: SCHNEIDER, Erwin, 65835 Liederbach (DE); WALLRAFEN, Werner, 65719 Hofheim (DE)
(86) Internationale Anmeldenummer: PCT/EP2007/060291
(87) Internationale Veröffentlichungsnummer: WO 2008/040680

(56) Entgegenhaltungen:
- EP-A- 1 275 939
- EP-A2- 1 669 573
- WO-A1-03/006805
- WO-A2-2006/024626
- DE-A1- 4 115 883
- DE-A1- 10 054 123
- DE-A1- 19 618 631
- JP-A- 2004 004 114
- US-A- 5 637 995

## Beschreibung

Die vorliegende Erfindung befasst sich mit einem Verfahren zur Herstellung eines Trägerelements, beispielsweise in der Form eines Gehäusedeckels oder zum Einsetzen in einen Gehäusedeckel, mit einem Winkelsensor zur Erfassung des Drehwinkels einer Welle und mit elektrischen Steckanschlüssen, wobei das Trägerelement aus Kunststoff, z. B. Duroplast oder Thermoplast besteht und elektrische Bauteile mit einem Kunststoff umspritzt oder umgossen werden. Gegenstand der vorliegenden Erfindung ist auch ein Trägerelement mit einem Winkelsensor für einen Aktuator einer Verbrennungskraft-Maschine, wobei der Winkelsensor einen dem Aktuator zugeordneten Magneten und elektronische Bauteile umfasst und mit elektrischen Steckanschlüssen, z. B. einem so genannten Kundenstecker, ausgerüstet ist.

Derartige Trägerelemente mit integriertem Winkelsensor finden bei Verbrennungskraftmaschinen Anwendung, wo sie die Drehstellung von Aktuatoren für die Steuerung des Verbrennungsmotors erfassen, beispielsweise bei der Laststeuerung, Abgasrückführung, Luftklappen im Ansaugtrakt oder der Verstellung der Schaufeln eines Turboladers. Die Ausbildung als Gehäusedeckel hat den Vorteil, dass der Winkelsensor selbst in einer Baueinheit geschützt verschlossen wird, wobei die elektrischen Anschlüsse als Kundenstecker ausgebildet sind, der nach Kundenwünschen konfiguriert ist und den elektrischen Anschluss an die Motorelektronik ermöglicht.

Der eigentliche Winkelsensor besteht dabei in der Regel aus wenigstens einem magnetoresistiven Messaufnehmer oder einem Hallsensor, z. B. in Halbleitertechnik, wobei dem Messaufnehmer auch bereits jeweils ein Chip mit der Auswerteelektronik zugeordnet ist. Häufig umfasst der Winkelsensor auch noch Kondensatoren, um die elektromagnetische Verträglichkeit zu verbessern. Vorteilhaft ist die redundante Ausbildung mit zwei Messaufnehmern und zwei zugeordneten Auswertelektroniken, um die Sicherheit beispielsweise beim Erfassen der Drehwinkelstellung einer Drosselklappe (E-Gas) zu erhöhen.

Die Herstellung z. B. von Gehäusedeckeln mit integriertem Winkelsensor erfolgt bislang in der Weise, dass der Messaufnehmer und die Auswerteelektronik von einem Chip-Hersteller vorkonfiguriert wird, d. h., der Chip für die Auswerteelektronik und der Messaufnehmer werden mit einem Stanzgitter zur Kontaktierung nach außen elektrisch verbunden, beispielsweise durch Bonden, und anschließend werden die elektronischen Bauteile mit einem Duroplasten einzeln umspritzt. Anschließend erfolgt eine Prüfung durch den Hersteller und der vorkonfigurierte Winkelsensor wird dann an einen Kunden geliefert. Dieser bezieht von einem weiteren Hersteller einen Gehäusedeckelrohling aus Kunststoff, der in der Regel im Spritzgussverfahren hergestellt wird, und stellt das Winkelsensor-Winkelsensormodul dadurch her, dass zunächst der vorkonfigurierte Winkelsensor mit einem so genannten Leadframe elektrisch durch Schweißen oder Löten verbunden wird. Anschließend wird der Leadframe in den Gehäuserohling eingelegt und der Leadframe mit einem Thermoplasten umspritzt, wobei eine separate Abdeckung die Sensorik schützen muss, weil diese sonst beschädigt würde. Abschließend muss nochmals eine Funktionskontrolle des fertigen Gehäusedeckels vorgenommen werden.

Zusammenfassend lässt sich das bisherige Herstellungsverfahren durch drei Spritzgießvorgänge charakterisieren, wobei sowohl das teilweise Umspritzen des Stanzgitters auf Seiten des Chip-Herstellers als auch das abschließende Umspritzen des Leadframes zur Verbindung mit dem Gehäusedeckel unter besonderen Prozessbedingungen stattfinden muss, um die Gefahr von Funktionsstörungen zu vermeiden. Schließlich sind auch zwei Funktionsüberprüfungen notwendig, nämlich auf Seiten des Chipherstellers nach Fertigstellung des Sensors und auf Seiten des Herstellers des Trägerelements nach dem Umspritzen des Leadframes.

Das Festlegen des eigentlichen Winkelsensors an dem Trägerelement durch Umspritzen führt auch zwangsläufig dazu, dass der Messaufnehmer von dem zu erfassenden Drehmagneten durch wenigstens zwei Kunststoffwandungen oder -schichten getrennt ist. Der daraus resultierende größere Abstand verschlechtert die Messgenauigkeit und erfordert stärkere Magneten.

Aus der DE 196 18 631 A1 ist eine Vorrichtung zur Messung von Dreh- oder Winkelbewegungen und ein Verfahren zur Herstellung dieser Vorrichtung bekannt. Ein Messwertaufnehmer enthält hierzu eingeschlossen in ein Gehäuse die zum Erzeugen des elektrischen Signals vorgesehenen Bauteile. Über ein Anschlusskabel werden die Signale aus dem Gehäuse herausgeführt. Dabei besteht das Gehäuse aus zwei Halbschalen, die aus Kunststoff gefertigt sind und die nach dem Einfügen der elektrischen Bauteile und Einlegen des Anschlusskabels durch Kleben oder Verschweißen verbunden sind. Der Innenraum der beiden verbundenen Halbschalen ist mit einem Heißschmelzkleber ausgefüllt.

Aus der DE 41 15 883 A1 ist ein Verfahren zum Herstellen eines Gussteils mit darin eingebetteten Elektroden bekannt.

Die DE 1 275 939 A2, US 5 637 995 A, EP 1 669 573 A2 und die WO 03/006805 A1 offenbaren jeweils einen Winkelsensor.

Aus der WO 2006/024626 A2 ist eine elektrische Baugruppe mit einer integrierten Schaltung bekannt, die mindestens einen Leistungshalbleiterelement und weitere elektronische Bauteile aufweist, die durch von einem Betablech gebildete Leiter miteinander und mit Anschlüssen verbunden sind.

Aus der DE 100 54 123 A1 ist ein Drehwinkelerfasser mit einer Sensorabdeckung bekannt, durch die ein Magnetsensorelement und ein Außenverbindungsanschluss einstückig gestaltet sind.

Die Aufgabe der vorliegenden Erfindung besteht darin, ein Verfahren zur Herstellung eines Gehäusedeckels oder sonstigen Trägerelements mit einem Winkelsensor der vorstehend beschriebenen Art anzugeben, das gegenüber den bekannten Herstellungsverfahren vereinfacht ist.

Erfindungsgemäß ist daher vorgesehen, dass die elektronischen Bauteile des Winkelsensors unmittelbar mit einem Leadframe elektrisch verbunden werden, der Leadframe ohne das Trägerelement mit den elektronischen Bauelementen mit einem Duroplasten zur Bildung eines Winkelsensormoduls umspritzt oder umgossen wird und das Winkelsensormodul schließlich in eine Aufnahme des Trägerelements eingelegt, befestigt und mit den elektrischen Anschlüssen verbunden wird.

Das Verfahren hat den Vorteil, dass nur noch zwei Spritzgießvorgänge durchgeführt werden müssen, wobei das bislang vorab vorgesehene teilweise Umspritzen eines mit Bauelementen bestückten Stanzgitters entfällt und die elektronischen Bauelemente des Winkelsensors unmittelbar mit dem Leadframe elektrisch verbunden werden. Dadurch reduziert sich die Anzahl der innerhalb des Winkelsensormoduls vorzusehenden elektrischen Verbindungen und das Risiko eines Funktionsausfalls wird vermindert. Vorteilhaft in diesem Zusammenhang ist auch, dass nach dem Umspritzen mit Duroplast nur eine einzige Funktionskontrolle durchzuführen ist.

Die elektronischen Bauelemente sind beispielsweise wenigstens ein Messaufnehmer und wenigstens eine einem Messaufnehmer zugeordnete Auswertelektronik, wobei als weitere Bauelemente Kondensatoren zur Verbesserung der elektromagnetischen Verträglichkeit mit dem Leadframe verbunden sind. Während für das Umspritzen des Leadframes mit den empfindlichen elektronischen Bauelementen und den beispielsweise durch Bonden, Löten oder Leitkleben hergestellten elektrischen Verbindungen vornehmlich Duroplast geeignet ist, kann das Trägerelement selbst auch aus anderen Kunststoffen bestehen, beispielsweise spritzgegossenem Thermoplast.

Eine bevorzugte Weiterbildung des Verfahrens kann vorsehen, dass der Leadframe durch unmittelbare Anlage an definierten Stellen an dem Trägerelement bzw. in dem Gehäusedeckel positioniert wird. Hierdurch lässt sich eine optimale Lage der Messaufnehmer in dem Gehäusedeckel ohne Toleranzeinflüsse durch den Kunststoff erreichen, die allerdings auch durch andere Maßnahmen sichergestellt werden kann.

Zur Bildung eines redundanten Systems mit wenigstens zwei Messaufnehmern wird vorgeschlagen, den Leadframe beispielsweise Z-förmig oder L-förmig umzubiegen, wobei an dem in das Gehäuseinnere ragenden Ende des Leadframes auf jeder Seite jeweils ein Messaufnehmer oder zwei Messaufnehmer nebeneinander elektrisch verbunden werden und der nach innen ragende Bereich des Leadframes vollständig mit Duroplast umspritzt wird. Diese Ausbildung stellt sicher, dass beide Messaufnehmer in einem rotierenden, homogenen Magnetfeld angeordnet werden können, so dass sie im Wesentlichen identische Ausgangssignale erzeugen. Um unnötige Materialansammlungen zu vermeiden, die insbesondere wegen der höheren thermisch relevanten Masse bei Temperaturkalibrierungen eine längere Wartezeit bedeutet, können im Bereich der Umspritzung des in das Gehäuse ragenden Bereiches rippenförmige Aussparungen vorgesehen werden.

Die elektrische Verbindung zwischen dem Winkelsensormodul und dem Trägerelement kann über Schweißverbindungen oder eine Steckverbindungen mit Klemmwirkung erfolgen, die auch einen mechanischen Halt gewährleisten können. Der mechanische Halt zwischen dem Winkelsensormodul und dem Gehäusedeckel kann auch durch Verkleben oder Verklipsen erreicht oder verbessert werden.

Gegenstand der vorliegenden Erfindung ist auch ein Trägerelement mit einem Winkelsensor für einen Aktuator einer Verbrennungskraftmaschine, der nach einem der vorstehend beschriebenen Verfahren vorgestellt worden ist. Der Winkelsensor umfasst einen auf einer Welle des Aktuators sitzenden, in einem Gehäuse rotierenden Drehmagneten und elektronische Bauteile sowie elektrische Anschlüsse. Ein solches Trägerelement besteht selbst aus einem Kunststoff, wie z. B. Duro- oder Thermoplast, mit dem ein separates Winkelsensormodul mechanisch und elektrisch verbunden ist, wobei das Winkelsensormodul einen Leadframe aufweist, der mit elektrischen Bauteilen des Winkelsensors verbunden ist, und der Leadframe mit den elektronischen Bauteilen getrennt von dem Trägerelement mit einem Duroplasten umspritzt oder umgossen sind, der Leadframe des Winkelsensormoduls in den Bereich zwischen dem wenigstens einen Messaufnehmer und der Auswertschaltung elektrisch isolierend vollständig von Duroplast umgeben ist und der wenigstens eine Messwertaufnehmer nur eine einzige Schicht aus Duroplast als Zwischenwand zu dem Drehmagnet aufweist. Die elektronischen Bauteile bestehen aus dem wenigstens einen Messaufnehmer und auch aus einer Auswertschaltung für das entsprechende Messaufnehmersignal. Als Messaufnehmer sind magnetisch basierte Messaufnehmer mit magnetoresistiven Eigenschaften oder mit wenigstens einem Hall-Element vorgesehen. Zur Verbesserung der elektromagnetischen Verträglichkeit ist der Leadframe mit wenigstens einem Kondensator elektrisch verbunden, der ebenfalls mit Duroplast umspritzt ist.

Ein großer Vorteil des beschriebenen Gehäusedeckels mit integriertem Winkelsensor besteht auch darin, dass der wenigstens eine Messaufnehmer nur mit einer einzigen Schicht aus Kunststoff überzogen ist. Dadurch lässt sich die Spaltbreite zwischen Messaufnehmer und bewegtem Magnetelement gegenüber zwei Kunststoffschichten, wie sie beim Stand der Technik anzutreffen sind, verringern, da fertigungstechnisch nur bestimmte Mindestschichtdicken bei Spritzgießvorgängen einzuhalten sind. Der Leadframe kann im Bereich des wenigstens einen Messwertaufnehmers ausgestellt sein, so dass dieser möglichst nahe an die Oberfläche innerhalb der Duroplastmasse heranreicht.

Das elektrisch isolierende Umschließen der Verbindungsbereiche des Leadframe zwischen dem Messwertaufnehmer der Auswertschaltung erlaubt das unmittelbare Befestigen des Winkelsensormoduls an dem Trägerelement ohne nachträgliches Isolieren, da die Leiter nicht durch Schmutzpartikel kurzgeschlossen werden können.

Eine redundante Sensorik lässt sich bei dem Winkelsensor-Winkelsensormodul z. B. dadurch realisieren, dass zwei Messaufnehmer parallel zueinander auf beiden Seiten des Leadframes oder nebeneinander angeordnet und jeweils mit einer getrennten oder gemeinsamen Auswertelektronik verbunden sind. Damit beide Messaufnehmer mit gleichen Magnetfeldern zusammenwirken können, ist es bevorzugt, dass die beiden parallel zueinander liegenden Messaufnehmer parallel zur Stirnfläche eines Domes aus Duroplast in diesem angeordnet sind, wobei der Leadframe Z-förmig oder L-förmig in diesen Vorsprung hineinragt.

Zur Vermeidung von Materialansammlungen kann der Duroplast im Bereich des Domes rippenförmige Aussparungen aufweisen.

Nachfolgend wird anhand der beigefügten Zeichnungen näher auf Ausführungsbeispiele der Erfindung eingegangen. Es zeigen:
- Fig. 1: eine schematische Darstellung eines Winkelsensormoduls für einen Gehäusedeckel;
- Fig. 2: einen schematischen Schnitt des Winkelsensormoduls aus Fig.1;
- Fig. 3: eine schematische Ansicht eines Winkelsensormoduls für einen Gehäusedeckel mit redundanter Sensorik;
- Fig. 4: einen schematischen Schnitt des Winkelsensormoduls aus Fig.3.
- Fig. 5: einen schematischen Teilschnitt eines Gehäusedecke mit einem eingesteckten Winkelsensormodul nach Fig. 6;
- Fig. 6: eine schematische Draufsicht auf das Winkelsensormodul aus Fig. 5;
- Fig. 7: einen schematischen schnitt einer weiteren Ausführungsform eines Winkelsensormoduls;
- Fig. 8: einen schematischen Teilschnitt eines Gehäusedeckels mit einem eingeklebten Winkelsensormodul nach Fig. 1 mit verschweißten elektrischen Kontakten.

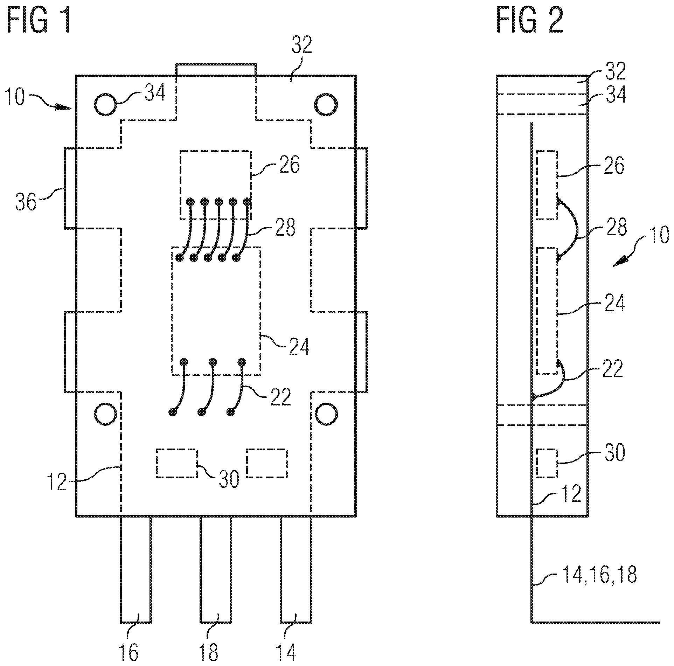

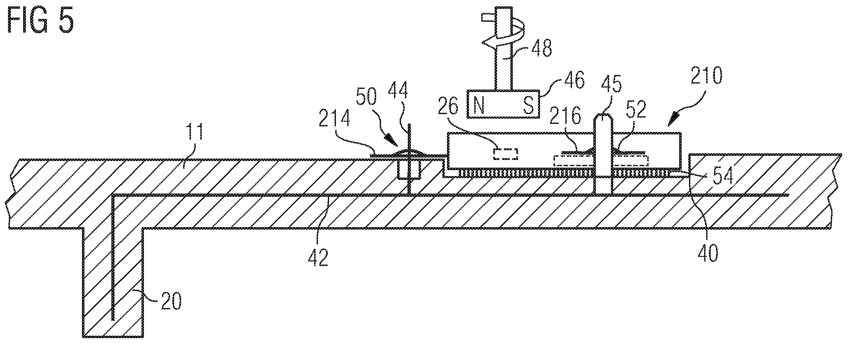

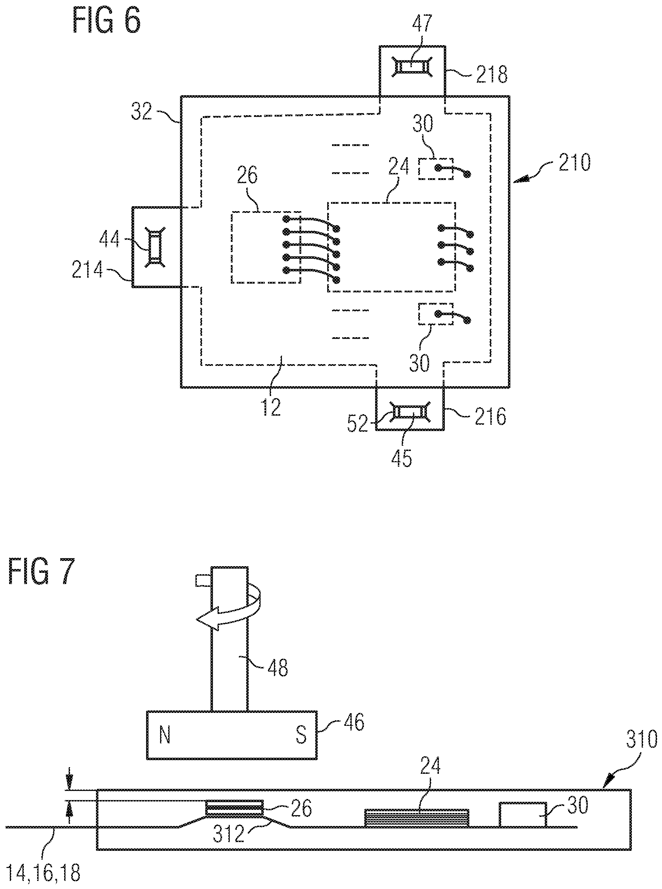

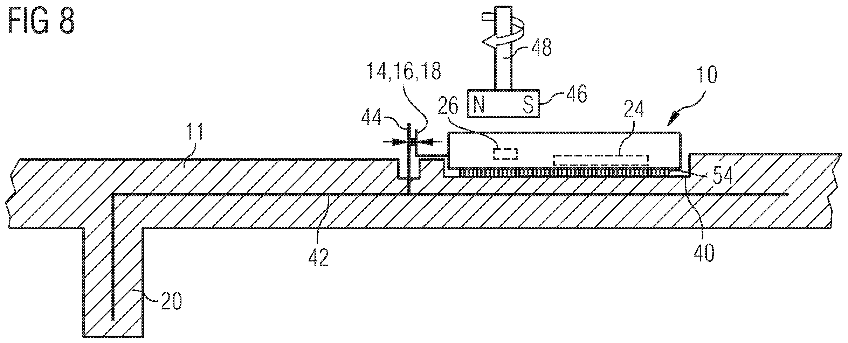

In Fig. 1 ist ein Winkelsensormodul 10 für einen Gehäusedeckel (siehe Fig. 5 und 8) dargestellt. Das Winkelsensormodul 10 besitzt einen Leadframe 12 mit freien Kontaktenden 14, 16, 18, welche als elektrische Kontakte zur Verbindung mit einem weiteren Leadframe in dem Gehäusedeckel dienen, der auch einen Kundenstecker 20 (siehe Fig. 5 und 6) bildet, der nach Kundenwünschen konfiguriert werden kann. Die drei elektrischen Kontakte 14, 16, 18 des Leadframes 12 sind über gebondete elektrische Verbindungen 22 mit einer Schaltung 24 unmittelbar verbunden, die eine Auswertelektronik für einen Messwertaufnehmer 26 darstellt. Der Messwertaufnehmer 26, der beispielsweise als magnetoresistiver Sensor oder als Hallsensor ausgebildet sein kann, ist wiederum über gebondete Zuleitungen 28 mit der Auswertelektronik 24 verbunden. Zudem sind zwischen den Kontakten 14, 16, 18 Kondensatoren 30 vorgesehen, die die elektromagnetische Verträglichkeit des Winkelsensormoduls 10 verbessern.

Der Leadframe 12 mit den kontaktierten elektrischen Bauelementen 24, 26, 30 ist mit einem Duroplast 32 überspritzt oder umgossen, der das Winkelsensormodul unempfindlich gegen äußere Einflüsse macht.

Das gezeigte Winkelsensormodul 10 wird abschließend in einen Gehäusedeckel eingesetzt, wobei die Positionierung über Bohrungen 34 oder auch durch Anschlagkanten 36 des Leadframes selbst erfolgen kann. Hiermit wird später im Zusammenhang mit Fig. 5 und 6 noch näher eingegangen.

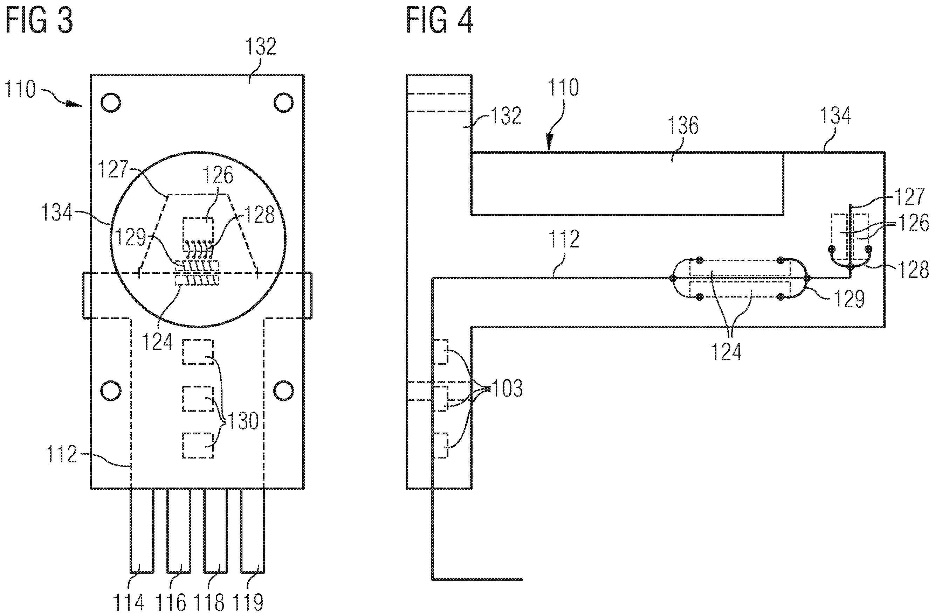

Ein redundantes Winkelsensormodul 110 ist in Fig. 3 und Fig. 4 gezeigt. Bei diesem Winkelsensormodul wird wiederum zunächst der Duroplastüberzug 132 um einen Leadframe 112 mit elektrisch verbundenen elektronischen Bauelementen 124, 126, 130 erzeugt und anschließend wird das Winkelsensormodul in den Gehäusedeckel eingesetzt.

Das in Fig. 3 gezeigte Winkelsensormodul verfügt über eine redundante Sensorik mit zwei Messaufnehmern 126, die parallel zueinander auf beiden Seiten eines Endes 127 eines Z-förmig abgewinkelten Leadframes 112 angeordnet sind. Die Messwertaufnehmer 126 sind durch Verbindungen 128 nicht unmittelbar mit zugeordneten Auswertelektroniken 124 verbunden, sondern über Leiterbahnen des Leadframes, die dann wiederum über Verbindungen 129 mit den Auswertschaltungen 124 verbunden sind. Bedingt durch die hier Z-förmige Ausbildung des Leadframes 112 entsteht nach dem Umspritzen mit dem Duroplasten 132 ein zylindrischer Dom 134, der teilweise rippenförmige Aussparungen 136 aufweist. Durch diese Ausbildung ist es möglich, beide Messwertaufnehmer 126 in einem homogenen Magnetfeld anzuordnen, das durch den Vorsprung 134 umgebende Magnetelemente gebildet ist. Entsprechend den zwei Ausgangskanälen der beiden Messwertaufnehmer 126 verfügt das Winkelsensormodul 110 über vier Anschlusskontakte 114, 116, 118, 119, die wiederum abgewinkelt sind. Da bei dem in Fig. 3 und 4 gezeigten Winkelsensormodul 110 zwei Ausgangskanäle vorgesehen sind, sind drei Kondensatoren 130 notwendig, um die elektromagnetische Verträglichkeit zu verbessern.

Fig. 5 zeigt im Querschnitt einen Gehäusedeckel 11, der eine Ausnehmung 40 aufweist, in welcher ein Winkelsensormodul 210 eingesetzt ist. Der Gehäusedeckel 11 besitzt einen zweiten Leadframe 42, der zur Bildung des Gehäuses mit Thermoplast oder Duroplast umspritzt ist. Der zweite Leadframe 42 bildet eine nach Kundenwünschen ausgebildete Steckverbindung 20, an die beispielsweise ein Stecker zur Verbindung mit dem Steuergerät eines Motors angeschlossen werden kann. Auf der gegenüberliegenden Gehäuseinnenseite verfügt der Leadframe über elektrische Kontaktanschlüsse 44, 45, 47 die zur Verbindung mit den elektrischen Anschlüssen 14, 16, 18 des Winkelsensormoduls 10 dienen. Dargestellt ist in Fig. 5 auch ein Drehmagnet 46, der auf eine Welle 48 eines Aktuators (nicht gezeigt) sitzt und dessen Drehwinkelstellung mit Hilfe des Winkelsensormoduls erfasst werden kann. Der Messwertaufnehmer 26 ist bei dem hier und in Fig. 6 gezeigten Winkelsensormodul 210 entsprechend der Lage des Drehmagnetes 46 positioniert.

Die Verbindung des zuvor beschriebenen Winkelsensormoduls 210 mit dem Gehäusedeckel 11 erfolgt durch einfaches Aufpressen, wobei im Kontaktbereich zwischen den elektrischen Anschlüssen 214, 216, 218 des Winkelsensormoduls 210 und den elektrischen Kontaktanschlüssen 44, 45, 47 des zweiten Leadframes 42 des Gehäusedeckels 11 vom Grundprinzip her bekannte Steckverbindungen 50 vorgesehen sind, bei welchen Federzungen 52 scharfkantig am Kontaktpartner anliegen. Da solche Steckverbindungen durch ihre starke Klemmung auch einen guten und genauen mechanischen Halt gewährleisten, kann bei geschickter Dimensionierung auf weitergehende Befestigungsmaßnahmen verzichtet werden, wobei die Positionierung über Passstifte (nicht gezeigt) an dem Kunststoffgehäuse des Gehäusedeckels 11 erfolgen kann, die in die Bohrungen 34 des Winkelsensormoduls 210 (siehe hierzu auch Fig. 1 und 2) eingreifen. Zur Verbesserung des Halts und Vermeidung einer Verlagerung des Winkelsensormoduls bei beispielsweise hohen Beschleunigungen, kann zwischen dem Winkelsensormodul 210 und dem Gehäusedeckel 11 eine Klebeschicht 54 vorgesehen sein.

In Fig. 7 ist eine weitere Ausführungsform eines Winkelsensormoduls 310 gezeigt, bei welcher der Leadframe 312 im Bereich des Messwertaufnehmers 26 durch Prägen trapezförmig ausgestellt ist, so dass dieser näher an dem Drehmagneten 46 liegt, d. h. die Duroplastschicht zwischen dem Magneten 46 und dem Messaufnehmer ist minimiert, wodurch sich eine bessere Messgenauigkeit ergibt und der Einsatz kleinerer Magnete ermöglicht wird. Die Anordnung der Auswertelektronik 24 und des Kondensators 30 entspricht der in Fig. 6 gezeigten Ausführungsform.

Fig. 8 zeigt wiederum einen Gehäusedeckel 11, der im Wesentlichen dem in Fig. 5 gezeigten Gehäusedeckel entspricht, wobei lediglich die elektrischen Kontaktanschlüsse 44, 45, 47 unmittelbar nebeneinander liegen und nicht der mechanischen Fixierung des Winkelsensormoduls dienen sollen. Die elektrische Verbindung zwischen den Anschlusslaschen 14, 16, 18 des Winkelsensormoduls und den elektrischen Kontaktanschlüssen 44, 45, 47 erfolgt hier durch ein Verschweißen, während der Halt des Winkelsensormoduls 10, das der Ausführungsform gemäß Fig. 1 entspricht, an dem Gehäusedeckel 11 in erster Linie durch die Klebeschicht 54 bewirkt wird. Die Positionierung erfolgt wiederum mit Hilfe der Bohrungen 34 und den nicht gezeigten, dem Gehäusedeckel 11 zugeordneten Passstiften oder mit Hilfe einer Klemm- und/oder Rastverbindung zwischen dem Winkelsensormodul und dem Gehäusedeckel.

## Patentansprüche

1. Verfahren zur Herstellung eines Trägerelements (11) mit einem Winkelsensor (10) für einen Aktuator einer Verbrennungskraftmaschine zur Erfassung des Drehwinkels einer Welle (48) und mit elektrischen Steckanschlüssen (20), wobei das Trägerelement aus Kunststoff besteht und elektronische Bauteile (12, 24, 26, 30) des Winkelsensors mit einem Kunststoff umspritzt oder umgossen werden,
wobei der Winkelsensor (10) elektronische Bauteile (12, 24, 26, 30) mit wenigstens einem Messwertaufnehmer (26), der zum Erfassen der Stellung eines auf einer Welle (48) des Aktuators sitzenden und drehbeweglichen Magneten (46) ausgebildet ist, einer Auswertschaltung (24) zur Auswertung des entsprechenden Messwertaufnehmer-Signals und Kondensatoren (30) zur Verbesserung der elektromagnetischen Verträglichkeit umfasst,
wobei als elektronische Bauelemente des Winkelsensors (10) wenigstens der Messwertaufnehmer (26), wenigstens die dem Messwertaufnehmer (26) zugeordnete Auswertschaltung (24) und die Kondensatoren (30) unmittelbar mit einem Leadframe (12) elektrisch verbunden werden,
wobei der Leadframe (12) mit den elektrisch verbundenen Bauelementen (24, 26, 30) derart mit einem Duroplast (32) zur Bildung eines Winkelsensormoduls (10) umspritzt oder umgossen wird, dass der wenigstens eine Messwertaufnehmer (26) nur eine einzige Schicht aus Duroplast als Zwischenwand zum Magneten (46) aufweist, wobei das Winkelsensormodul (10) schließlich in eine Aufnahme (40) des Trägerelements (11) eingelegt, befestigt und mit den Steckanschlüssen (20) anschließend verbunden wird,
wobei das Trägerelement (11) als Gehäusedeckel aus Duroplast oder Thermoplast mit den Steckanschlüssen (20) spritzgegossen wird.

2. Verfahren nach Anspruch 1, wobei die Kontaktierung der Bauelemente (24, 26, 30) durch Bonden, Löten und/oder Leitkleben erfolgt.

3. Verfahren nach einem der vorhergehenden Ansprüche,
wobei der Leadframe (12) durch unmittelbare Anlage an definierten Stellen an dem Trägerelement bzw. in dem Gehäusedeckel positioniert wird.

4. Verfahren nach einem der vorhergehenden Ansprüche,
wobei der Leadframe (112) Z-förmig oder L-förmig umgebogen wird, wobei mit dem in das Gehäuseinnere ragenden Ende (127) des Leadframes (112) auf jeder Seite jeweils ein Messaufnehmer (126) oder zwei Messaufnehmer seitlich nebeneinander elektrisch verbunden werden und der nach innen ragende Bereich des Leadframes (112) vollständig mit Duroplast umspritzt oder umgossen wird.

5. Verfahren nach Anspruch 4, wobei der Duroplast im Bereich des Domes (134) rippenartig ausgespart wird.

6. Verfahren nach einem der vorhergehenden Ansprüche,
**wobei** das Winkelsensormodul (10) mit dem Trägerelement (11) über Steckverbindungen (50) mit Klemmwirkung mechanisch und/oder elektrisch verbunden wird.

7. Verfahren nach einem der Ansprüche 1 bis 5, **wobei** der Leadframe des Winkelsensormoduls (10) über eine Löt- oder Schweißverbindung elektrisch mit dem Leadframe (42) des Trägerelements (11) verbunden wird.

8. Verfahren nach einem der vorhergehenden Ansprüche,
**wobei** das Winkelsensormodul (10) mit dem Trägerelement (11) verklebt wird.

9. Trägerelement (11) mit einem Winkelsensor (10) für einen Aktuator einer Verbrennungskraftmaschine, wobei der Winkelsensor elektronische Bauteile (24 ,26 ,30) mit wenigstens einem Messwertaufnehmer (26), der zum Erfassen der Stellung eines auf einer Welle (48) des Aktuators sitzenden und drehbeweglichen Magneten (46) ausgebildet ist, und einer Auswertschaltung (24) zur Auswertung des entsprechenden Messaufnehmer-Signals umfasst und mit elektrischen Steckanschlüssen(20) ausgerüstet ist,
wobei das Trägerelement (11) selbst aus Kunststoff gefertigt ist und mit dem Trägerelement ein separates Winkelsensormodul (10) mechanisch und elektrisch verbunden ist, wobei das Winkelsensormodul (10) einen Leadframe (12) aufweist, der mit elektrischen Bauelementen (24, 26, 30) des Winkelsensors verbunden ist, und der Leadframe (12) mit den elektronischen Bauelementen (24, 26, 30) getrennt von dem Trägerelement mit Duroplast (32) umspritzt oder umgossen sind, wobei der Leadframe (12) des Winkelsensormoduls in dem Bereich zwischen dem wenigstens einen Messwertaufnehmer (26) und der Auswertschaltung (24) elektrisch isolierend vollständig von Duroplast (32) umgeben ist und der wenigstens eine Messwertaufnehmer (26) nur eine einzige Schicht aus Duroplast als Zwischenwand zum Magneten (46) aufweist,
wobei das Trägerelement (11) als Gehäusedeckel aus Duroplast oder Thermoplast mit den Steckanschlüssen (20) mittels Spritzgießens ausgebildet ist, und
wobei mit dem Leadframe wenigstens ein Kondensator (30) elektrisch verbunden ist, der ebenfalls im Winkelsensormodul (10) umspritzt ist.

10. Trägerelement nach Anspruch 9, wobei der wenigstens eine Messwertaufnehmer (26) als magnetisch basierter Messwertaufnehmer mit magnetoresistiven Elementen oder mit wenigstens einem Hall-Element ausgebildet ist.

11. Trägerelement nach einem der Ansprüche 9 bis 10,
**wobei** zwei Messwertaufnehmer (126) parallel zueinander auf beiden Seiten des Leadframes (112) oder zwei Messwertaufnehmer nebeneinander auf einer Seite des Leadframes angeordnet und mit mindestens einer Auswertelektronik elektrisch (124) verbunden sind.

12. Trägerelement nach Anspruch 11, **wobei** die beiden Messwertaufnehmer (126) parallel zur Stirnfläche eines zylindrischen Domes (134) aus Duroplast in diesem angeordnet sind, wobei der Leadframe (12) in diesen Vorsprung (134) hineinragt.

13. Trägerelement nach Anspruch 12, **wobei** der Dom (134) rippenartige Aussparungen (136) aufweist.

14. Trägerelement nach einem der Ansprüche 9 bis 13,
**wobei** der Leadframe (12) im Bereich des Messwertaufnehmers (26) durch eine trapezförmige Biegung oder Prägung (312) so ausgebildet ist, dass die Kunststoffwandstärke im Bereich des Messwertaufnehmers minimiert ist.

15. Trägerelement nach einem der Ansprüche 9 bis 14,
**wobei** zwischen einem Leadframe (42) des Trägerelements und dem Winkelsensormodul (10) elektrische Steckverbindungen vorgesehen sind.

## Claims

1. Method for producing a support element (11) having an angle sensor (10) for an actuator of an internal combustion engine for sensing the angle of rotation of a shaft (48) and having electrical plug-in connections (20), wherein the support element consists of plastic, and electronic components (12, 24, 26, 30) of the angle sensor are overmoulded or encapsulated with a plastic,
wherein the angle sensor (10) comprises electronic components (12, 24, 26, 30) having at least one measured-value pickup (26), which is designed for sensing the position of a magnet (46) which sits on a shaft (48) of the actuator and is rotationally movable, an evaluation circuit (24) for evaluating the corresponding measured-value pickup signal and capacitors (30) for improving the electromagnetic compatibility,
wherein, as electronic components of the angle sensor (10), at least the measured-value pickup (26), at least the evaluation circuit (24) associated with the measured-value pickup (26) and the capacitors (30) are electrically connected directly to a leadframe (12),
wherein the leadframe (12) with the electrically connected components (24, 26, 30) is overmoulded or encapsulated with a thermoset (32) to form an angle sensor module (10) in such a way that the at least one measured-value pickup (26) has only a single layer of thermoset as a partition from the magnet (46),
wherein the angle sensor module (10) is finally inserted into a receptacle (40) in the support element (11), is secured and is then connected to the plug-in connections (20),
wherein the support element (11) is injection-moulded as a housing lid comprising thermoset or thermoplastic with the plug-in connections (20).

2. Method according to Claim 1, wherein the contact with the components (24, 26, 30) is made by bonding, soldering and/or conductive adhesive bonding.

3. Method according to either of the preceding claims, wherein the leadframe (12) is positioned by means of direct contact with defined points on the support element or in the housing lid.

4. Method according to one of the preceding claims, wherein the leadframe (112) is bent around in a Z shape or L shape, with a respective measured-value pickup (126) or two measured-value pickups being electrically connected side by side on each side to that end (127) of the leadframe (112) which projects into the housing interior, and the inwardly projecting region of the leadframe (112) being completely overmoulded or encapsulated with thermoset.

5. Method according to Claim 4, wherein the thermoset is hollowed out in the form of ribs in the region of the dome (134) .

6. Method according to one of the preceding claims, wherein the angle sensor module (10) is mechanically and/or electrically connected to the support element (11) by means of plug-in connections (50) with a clamping action.

7. Method according to one of Claims 1 to 5, wherein the leadframe of the angle sensor module (10) is electrically connected to the leadframe (42) of the support element (11) by means of a solder or weld joint.

8. Method according to one of the preceding claims, wherein the angle sensor module (10) is adhesively bonded to the support element (11).

9. Support element (11) having an angle sensor (10) for an actuator of an internal combustion engine, wherein the angle sensor comprises electronic components (24, 26, 30) having at least one measured-value pickup (26), which is designed for sensing the position of a magnet (46) which sits on a shaft (48) of the actuator and is rotationally movable, and an evaluation circuit (24) for evaluating the corresponding measured-value pickup signal and is equipped with electrical plug-in connections (20),
wherein the support element (11) itself is made from plastic and the support element has a separate angle sensor module (10) mechanically and electrically connected to it, wherein the angle sensor module (10) has a leadframe (12) which is connected to electrical components (24, 26, 30) of the angle sensor, and the leadframe (12) with the electronic components (24, 26, 30) is overmoulded or encapsulated with thermoset (32) separately from the support element, wherein the leadframe (12) of the angle sensor module is completely surrounded by thermoset (32), so as to be electrically insulating, in the region between the at least one measured-value pickup (26) and the evaluation circuit (24), and the at least one measured-value pickup (26) has only a single layer of thermoset as a partition from the magnet (46),
wherein the support element (11) is formed by means of injection moulding as a housing lid comprising thermoset or thermoplastic with the plug-in connections (20), and
wherein the leadframe has at least one capacitor (30), which is likewise overmoulded in the angle sensor module (10), electrically connected to it.

10. Support element according to Claim 9, wherein the at least one measured-value pickup (26) is in the form of a magnetically based measured-value pickup with magnetoresistive elements or with at least one Hall element.

11. Support element according to either of Claims 9 and 10, wherein two measured-value pickups (126) are arranged parallel to one another on both sides of the leadframe (112) or two measured-value pickups are arranged next to one another on one side of the leadframe and are electrically (124) connected to at least one evaluation electronics unit.

12. Support element according to Claim 11, wherein the two measured-value pickups (126) are arranged in a cylindrical dome (134) comprising thermoset parallel to the abutting face of said dome, with the leadframe (12) protruding into this projection (134).

13. Support element according to Claim 12, wherein the dome (134) has rib-like hollows (136).

14. Support element according to one of Claims 9 to 13, wherein the leadframe (12) in the region of the measured-value pickup (26) is formed by a trapezoidal bend or embossment (312) such that the plastic wall thickness is minimized in the region of the measured-value pickup.

15. Support element according to one of Claims 9 to 14, wherein electrical plug-in connections are provided between a leadframe (42) of the support element and the angle sensor module (10).

## Revendications

1. Procédé de fabrication d'un élément porteur (11) comprenant un capteur d'angle (10) pour un actionneur d'un moteur à combustion interne destiné à détecter l'angle de rotation d'un arbre (48) et comprenant des bornes à enfichage (20) électriques, l'élément porteur se composant de matière plastique et des composants électroniques (12, 24, 26, 30) du capteur d'angle étant surmoulés ou enrobés avec une matière plastique,
le capteur d'angle (10) comprenant des composants électroniques (12, 24, 26, 30) avec au moins un enregistreur de valeur mesurée (26), lequel est configuré pour détecter la position d'un aimant (46) reposant sur un arbre (48) de l'actionneur et mobile en rotation, un circuit d'interprétation (24) destiné à interpréter le signal d'enregistreur de valeur mesurée correspondant et des condensateurs (30) destinés à améliorer la compatibilité électromagnétique,
en tant que composants électroniques du capteur d'angle (10), au moins l'enregistreur de valeur mesurée (26), au moins le circuit d'interprétation (24) associé à l'enregistreur de valeur mesurée (26) et les condensateurs (30) étant reliés électriquement directement à une grille de connexion (12),
la grille de connexion (12) avec les composants (24, 26, 30) reliés électriquement étant surmoulée ou enrobée avec une résine thermodurcissable (32) en vue de former un module capteur d'angle (10) de telle sorte que l'au moins un enregistreur de valeur mesurée (26) ne possède qu'une seule couche de résine thermodurcissable en tant que paroi intermédiaire par rapport à l'aimant (46),
le module capteur d'angle (10) étant finalement introduit dans un logement (40) de l'élément porteur (11), fixé et ensuite relié aux bornes à enfichage (20),
l'élément porteur (11) en tant que couvercle de boîtier en résine thermodurcissable ou en thermoplastique étant moulé par injection avec les bornes à enfichage (20).

2. Procédé selon la revendication 1, l'établissement du contact avec les composants (24, 26, 30) s'effectuant par métallisation, brasage et/ou collage conducteur.

3. Procédé selon l'une des revendications précédentes, la grille de connexion (12) étant positionnée par application directe à des endroits définis sur l'élément porteur ou dans le couvercle de boîtier.

4. Procédé selon l'une des revendications précédentes, la grille de connexion (112) étant cintrée en forme de Z ou en forme de L, un enregistreur de mesure (126) ou deux enregistreurs de mesure l'un à côté de l'autre latéralement étant respectivement reliés électriquement de chaque côté à l'extrémité (127) de la grille de connexion (112) qui fait saillie à l'intérieur du boîtier et la zone de la grille de connexion (112) qui fait saillie vers l'intérieur étant entièrement surmoulée ou enrobée avec de la résine thermodurcissable.

5. Procédé selon la revendication 4, la résine thermodurcissable étant évidée à la manière de nervures dans la zone du dôme (134).

6. Procédé selon l'une des revendications précédentes, le module capteur d'angle (10) étant relié mécaniquement et/ou électriquement à l'élément porteur (11) par le biais de liaisons à enfichage (50) avec effet de serrage.

7. Procédé selon l'une des revendications 1 à 5, la grille de connexion du module capteur d'angle (10) étant reliée électriquement à la grille de connexion (42) de l'élément porteur (11) par le biais d'une connexion brasée ou soudée.

8. Procédé selon l'une des revendications précédentes, le module capteur d'angle (10) étant collé à l'élément porteur (11) .

9. Élément porteur (11) comprenant un capteur d'angle (10) pour un actionneur d'un moteur à combustion interne, le capteur d'angle comprenant des composants électroniques (24, 26, 30) avec au moins un enregistreur de valeur mesurée (26), lequel est configuré pour détecter la position d'un aimant (46) reposant sur un arbre (48) de l'actionneur et mobile en rotation, et un circuit d'interprétation (24) destiné à interpréter le signal d'enregistreur de valeur mesurée correspondant, et étant équipé de bornes à enfichage (20) électriques,
l'élément porteur (11) lui-même étant fabriqué en matière plastique et un module capteur d'angle (10) séparé étant relié mécaniquement et électriquement à l'élément porteur, le module capteur d'angle (10) possédant une grille de connexion (12) qui est reliée aux composants électriques (24, 26, 30) du capteur d'angle et la grille de connexion (12) avec les composants électroniques (24, 26, 30) étant surmoulée ou enrobée avec une résine thermodurcissable (32) séparément de l'élément porteur, la grille de connexion (12) du module capteur d'angle étant entièrement entourée de résine thermodurcissable (32) de manière électriquement isolante dans la zone entre l'au moins un enregistreur de valeur mesurée (26) et le circuit d'interprétation (24) et l'au moins un enregistreur de valeur mesurée (26) ne possédant qu'une seule couche de résine thermodurcissable en tant que paroi intermédiaire par rapport à l'aimant (46),
l'élément porteur (11) en tant que couvercle de boîtier en résine thermodurcissable ou en thermoplastique étant réalisé par moulage par injection avec les bornes à enfichage (20) et au moins un condensateur (30) étant relié électriquement à la grille de connexion, lequel est également surmoulé dans le module capteur d'angle (10).

10. Élément porteur selon la revendication 9, l'au moins un enregistreur de valeur mesurée (26) étant réalisé sous la forme d'un enregistreur de valeur mesurée basé sur le magnétisme comprenant des éléments magnétorésistifs ou comprenant au moins un élément à effet Hall.

11. Élément porteur selon l'une des revendications 9 et 10, deux enregistreurs de valeur mesurée (126) étant disposés parallèlement l'un à l'autre des deux côtés de la grille de connexion (112) ou deux enregistreurs de valeur mesurée étant disposés l'un à côté de l'autre sur un côté de la grille de connexion et étant reliés électriquement à au moins une électronique d'interprétation (124).

12. Élément porteur selon la revendication 11, les deux enregistreurs de valeur mesurée (126) étant disposés parallèlement à la surface frontale d'un dôme cylindrique (134) en résine thermodurcissable, dans celui-ci, la grille de connexion (12) pénétrant dans cette partie saillante (134).

13. Élément porteur selon la revendication 12, le dôme (134) possédant des évidements (136) de type nervure.

14. Élément porteur selon l'une des revendications 9 à 13, la grille de connexion (12) étant configurée dans la zone de l'enregistreur de valeur mesurée (26) par un pliage trapézoïdal ou un estampage (312) de telle sorte que l'épaisseur de paroi en matière plastique est réduite au minimum sans la zone de l'enregistreur de valeur mesurée.

15. Élément porteur selon l'une des revendications 9 à 14, des liaisons à enfichage électriques se trouvant entre une grille de connexion (42) de l'élément porteur et le module capteur d'angle (10).
